(19) Europäisches Patentamt
European Patent Office
Office européen des brevets

(11) **EP 4 400 851 A1**

(12) **EUROPÄISCHE PATENTANMELDUNG**

(43) Veröffentlichungstag:
**17.07.2024   Patentblatt 2024/29**

(21) Anmeldenummer: **23151751.7**

(22) Anmeldetag: **16.01.2023**

(51) Internationale Patentklassifikation (IPC):
**G01R 31/34** (2020.01)    **G01R 33/02** (2006.01)
**H02P 21/14** (2016.01)

(52) Gemeinsame Patentklassifikation (CPC):
**G01R 31/34; G01R 33/02; H02P 21/141**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **Siemens Aktiengesellschaft
80333 München (DE)**

(72) Erfinder:
• **Künzel, Stefan
91056 Erlangen (DE)**
• **Wieser, Norbert
91322 Gräfenberg (DE)**

(74) Vertreter: **Siemens Patent Attorneys
Postfach 22 16 34
80506 München (DE)**

(54) **MESSUNG UND AUSWERTUNG VON MAGNETFLÜSSEN EINES PERMANENTERREGTEN SYNCHRONMOTORS**

(57)   Die Erfindung betrifft ein Verfahren zur Messung von Magnetflüssen ($\psi_d$, $\psi_q$) eines permanenterregten Synchronmotors, dessen Motorspannungen durch einen Stromrichter erzeugt werden, in Abhängigkeit von Motorströmen ($i_d$, $i_q$) des Synchronmotors. Dabei werden mehrere Einzelmessungen (El bis E4) durchgeführt. Bei jeder Einzelmessung (El bis E4) wird eine Motorspannung als ein Spannungspuls bei anfänglich verschwindendem Motorstrom erzeugt. Aus einem d-Anteil ($U_d$) der Motorspannung wird durch Integration über die Pulsdauer des Spannungspulses ein d-Anteil ($W_d$) des Magnetflusses ermittelt, aus einem q-Anteil ($U_q$) der Motorspannung wird durch Integration über die Pulsdauer des Spannungspulses ein q-Anteil ($\psi_q$) des Magnetflusses ermittelt und es werden ein Messwert für einen d-Anteil ($i_d$) und ein Messwert für einen q-Anteil ($i_q$) des Motorstroms erfasst. Ferner betrifft die Erfindung ein Mess- und Auswertesystem (3) für die Messung und Auswertung von Magnetflüssen ($\psi_d$, $\psi_q$) eines permanenterregten Synchronmotors.

FIG 1

**Beschreibung**

Die Erfindung betrifft ein Verfahren zur Messung von Magnetflüssen eines permanenterregten Synchronmotors, dessen Motorspannungen durch einen Stromrichter erzeugt werden, in Abhängigkeit von Motorströmen des Synchronmotors. Ferner betrifft die Erfindung ein Mess- und Auswertesystem für die Messung und Auswertung von Magnetflüssen eines derartigen Synchronmotors.

Bei permanenterregten Synchronmotoren gibt es eine Entwicklung hin zu kleineren Motoren mit mehr Überlastfähigkeit, was zur Folge hat, dass das nichtlineare Verhalten dieser Motoren stärker ausgeprägt ist und die Modelle der Motorregelung erweitert werden müssen, um diese Effekte zu berücksichtigen. Dazu braucht man eine Messung von Daten, die diese Nichtlinearität beschreiben. Dabei haben sich Magnetflüsse als Funktion des Motorstroms als sehr günstige Beschreibung herausgestellt, insbesondere der d-Anteil des Magnetflusses und der q-Anteil des Magnetflusses als Funktion des d-Anteils und des q-Anteils des Motorstroms in einem rotorfesten d/q-Koordinatensystem. Der d-Anteil einer Größe wie eines Motorstroms, eines Magnetflusses oder einer Motorspannung wird häufig auch als die d-Komponente der Größe in dem d/q-Koordinatensystem oder als Anteil der Größe in der d-Richtung des d/q-Koordinatensystems bezeichnet. Entsprechendes gilt für den q-Anteil einer Größe.

Bisher werden beispielsweise im Rahmen der Motordatenidentifikation differentielle Induktivitäten in d-Richtung und in q-Richtung gemessen. Die Messung erfolgt mit einem Stromoffset und einem überlagerten sinusförmigen Messstrom. Die Messung in d-Richtung kann im Stillstand des Rotors des Synchronmotors erfolgen, die Messung in q-Richtung führt jedoch zu einer starken Bewegung und Beschleunigung des Rotors des Motors. Zum Teil kann die Messung aufgrund der Bewegung nicht bis zum Ende erfolgen, weil es andernfalls zu einer Überschreitung der Maximaldrehzahl des Motors kommen würde. Mit einer solchen Messung kann der Magnetfluss durch Integration der Induktivität errechnet werden, allerdings erhält man dann den Fluss in Abhängigkeit von nur einer Variablen. Eine derartige Messung mit zwei veränderlichen Variablen nimmt relativ viel Zeit in Anspruch.

Der Erfindung liegt die Aufgabe zugrunde, ein verbessertes Verfahren zur Messung von Magnetflüssen eines permanenterregten Synchronmotors, dessen Motorspannungen durch einen Stromrichter erzeugt werden, in Abhängigkeit von Motorströmen des Synchronmotors anzugeben. Ferner liegt der Erfindung die Aufgabe zugrunde, ein verbessertes Mess- und Auswertesystem für die Messung und Auswertung von Magnetflüssen eines permanenterregten Synchronmotors anzugeben.

Die Aufgabe wird erfindungsgemäß durch ein Verfahren mit den Merkmalen des Anspruchs 1 und ein Mess- und Auswertesystem mit den Merkmalen des Anspruchs 15 gelöst.

Vorteilhafte Ausgestaltungen der Erfindung sind Gegenstand der Unteransprüche.

Bei dem erfindungsgemäßen Verfahren zur Messung von Magnetflüssen eines permanenterregten Synchronmotors, dessen Motorspannungen durch einen Stromrichter erzeugt werden, in Abhängigkeit von Motorströmen des Synchronmotors werden mehrere Einzelmessungen durchgeführt, wobei bei jeder Einzelmessung

- eine Motorspannung als ein Spannungspuls bei anfänglich verschwindendem Motorstrom erzeugt wird,
- aus einem d-Anteil der Motorspannung durch Integration über die Pulsdauer des Spannungspulses ein d-Anteil des Magnetflusses ermittelt wird,
- aus einem q-Anteil der Motorspannung durch Integration über die Pulsdauer des Spannungspulses ein q-Anteil des Magnetflusses ermittelt wird und
- ein Messwert für einen d-Anteil und ein Messwert für einen q-Anteil des Motorstroms erfasst werden.

Unter einem Spannungspuls wird eine Spannung verstanden, die nur während einer kurzen Pulsdauer von Null verschiedene Werte mit einer bestimmten Amplitude annimmt. Dabei kann die Spannung während der Pulsdauer mehrfach den Wert Null annehmen, das heißt aus mehreren Einzelpulsen bestehen. Beispielsweise wird ein Spannungspuls durch ein PDM-Signal (= Pulsdauermodulationssignal) erzeugt.

Mit anderen Worten wird bei dem erfindungsgemäßen Verfahren also eine Vielzahl von Einzelmessungen durchgeführt, bei denen jeweils bei anfänglich verschwindendem Motorstrom ein d-Anteil und ein q-Anteil des Magnetflusses ermittelt und ein d-Anteil und ein q-Anteil des Motorstroms gemessen werden. Der d-Anteil und der q-Anteil des Magnetflusses werden jeweils durch Integration des entsprechenden Anteils der Motorspannung über die Pulsdauer des Spannungspulses ermittelt, mit dem die Motorspannung bei der Einzelmessung erzeugt wird. Durch geeignet gewählte Spannungspulse für die Einzelmessungen können der d-Anteil und der q-Anteil des Magnetflusses jeweils als Funktion des d-Anteils und des q-Anteils des Motorstroms ermittelt werden. Da der Motorstrom zu Beginn jeder Einzelmessung verschwindet und die Spannungspulse relativ kurz sind, können die Einzelmessungen im Quasistillstand des Rotors des Synchronmotors durchgeführt werden, so dass die oben genannten Probleme, die von einer starken Bewegung des Rotors herrühren, vermieden werden können.

Bei einer Ausgestaltung der Erfindung ist der d-Anteil der Motorspannung, durch dessen Integration der d-Anteil des Magnetflusses ermittelt wird, die Differenz eines d-Anteils einer gemessenen Ausgangsspannung des Stromrichters und eines ohmschen Anteils eines Spannungsabfalls an einer Statorwicklung des Synchronmotors, und der q-Anteil der Motorspannung, durch dessen Integration der q-Anteil des Magnetflusses ermittelt wird, ist die Differenz eines q-Anteils der gemessenen Ausgangsspannung des Stromrichters und des ohmschen Anteils des Spannungsabfalls an der Statorwicklung des Synchronmotors.

Die vorgenannte Ausgestaltung der Erfindung verwendet also Messwerte für die motorseitige Ausgangsspannung des Stromrichters, die an Klemmen des Synchronmotors anliegt, und berücksichtigt den ohmschen Anteil eines Spannungsabfalls an der Statorwicklung des Synchronmotors.

Bei einer zur vorgenannten Ausgestaltung alternativen Ausgestaltung der Erfindung ist der d-Anteil der Motorspannung, durch dessen Integration der d-Anteil des Magnetflusses ermittelt wird, die Differenz eines Sollwerts für einen d-Anteil einer Ausgangsspannung des Stromrichters und eines ohmschen Anteils eines Spannungsabfalls an einer Statorwicklung des Synchronmotors und eines modellierten Spannungsabbildungsfehlers für den d-Anteil der Ausgangsspannung des Stromrichters ist, und der q-Anteil der Motorspannung, durch dessen Integration der q-Anteil des Magnetflusses ermittelt wird, ist die Differenz eines Sollwerts für einen q-Anteil der Ausgangsspannung des Stromrichters und des ohmschen Anteils des Spannungsabfalls an der Statorwicklung des Synchronmotors und eines modellierten Spannungsabbildungsfehlers für den q-Anteil der Ausgangsspannung des Stromrichters. Unter dem Spannungsabbildungsfehler für einen Anteil der Ausgangsspannung des Stromrichters wird die Differenz des Sollwertes für diesen Anteil der Ausgangsspannung des Stromrichters und des tatsächlichen Wertes dieses Anteils der Ausgangsspannung des Stromrichters verstanden.

Die vorgenannte Ausgestaltung der Erfindung verwendet also Sollwerte statt Messwerte für die Ausgangsspannung des Stromrichters, um die Magnetflüsse zu ermitteln. Daher ist sie aufgrund der nicht genau bekannten Spannungsabbildungsfehler etwas ungenauer als die auf Messwerten für die Ausgangsspannungen des Stromrichters basierende Ermittlung der Magnetflüsse, hat jedoch den Vorteil, dass die Ausgangsspannungen des Stromrichters nicht gemessen werden müssen.

Bei beiden vorgenannten Ausgestaltungen der Erfindung wird der ohmsche Spannungsabfall an der Statorwicklung des Synchronmotors beispielsweise aus einem ohmschen Widerstand der Statorwicklung und dem Motorstrom berechnet.

Vorzugsweise ist der bei einer Einzelmessung erfasste Messwert für den d-Anteil des Motorstroms ein Wert, für den ein Betrag des d-Anteils des Motorstroms maximal ist, und der bei einer Einzelmessung erfasste Messwert für den q-Anteil des Motorstroms ist ein Wert, für den ein Betrag des q-Anteils des Motorstroms maximal ist. Diese Ausgestaltung der Erfindung berücksichtigt, dass der Motorstrom während einer Einzelmessung von Null auf einen Maximalwert ansteigt, der für die Messwerte für den d-Anteil und den q-Anteil des Motorstroms herangezogen wird. Wenn bei der Strommessung beispielsweise nur Mittelwerte der Motorströme über jeweils eine Taktperiode einer Pulsdauermodulation gemessen werden, wird nach dem Spannungspuls, der bei einer Einzelmessung erzeugt wird, noch eine Taktperiode lang eine verschwindende Motorspannung erzeugt und der Motorstrom wird für diese Taktperiode gemessen, da er dann noch annähernd seinen Maximalwert aufweist.

Bei einer weiteren Ausgestaltung der Erfindung werden Messsequenzen von jeweils vier aufeinander folgenden Einzelmessungen durchgeführt, wobei bei jeder Messsequenz

- bei den Einzelmessungen jeweils wenigstens annähernd derselbe d-Anteil der Motorspannung und wenigstens annähernd derselbe Betrag des q-Anteils der Motorspannung erzeugt werden,
- bei einer auf eine erste Einzelmessung folgenden zweiten Einzelmessung und bei einer auf die zweite Einzelmessung folgenden dritten Einzelmessung das Vorzeichen des q-Anteils der Motorspannung gegenüber der ersten Einzelmessung invertiert wird und
- bei einer auf die dritte Einzelmessung folgenden vierten Einzelmessung ein q-Anteil der Motorspannung mit demselben Vorzeichen wie bei der ersten Einzelmessung erzeugt wird.

Die vorgenannte Ausgestaltung der Erfindung zielt auf möglichst geringe Bewegungen und Lageänderungen des Rotors des Synchronmotors während der Messungen. Dies wird zum einen dadurch erreicht, dass bei der zweiten Einzelmessung einer Messsequenz das Vorzeichen des q-Anteils der Motorspannung gegenüber der ersten Einzelmessung invertiert wird, um die durch die erste Einzelmessung verursachte Bewegung des Rotors zu stoppen. Bei der dritten Einzelmessung der Messsequenz wird der Rotor dann entgegensetzt zu der ersten Einzelmessung bewegt, um die durch die erste Einzelmessung verursachte Lageänderung des Rotors zurückzufahren. Bei der vierten Einzelmessung einer Messsequenz wird das Vorzeichen des q-Anteils der Motorspannung gegenüber der dritten Einzelmessung invertiert, um die durch die dritte Einzelmessung verursachte Bewegung des Rotors zu stoppen. Nach einer Messsequenz befindet sich der Motor daher zumindest annähernd in demselben Zustand wie vor der Messsequenz.

Bei einer weiteren Ausgestaltung der Erfindung werden für jede Messsequenz ein Mittelwert der bei den Einzelmessungen ermittelten d-Anteile des Magnetflusses und ein Mittelwert der bei den Einzelmessungen erfassten Messwerte für den d-Anteil des Motorstroms gebildet.

Bei einer weiteren Ausgestaltung der Erfindung werden für jede Messsequenz ein Mittelwert der bei der ersten Einzelmessung und der vierten Einzelmessung ermittelten q-Anteile des Magnetflusses und ein Mittelwert der bei der ersten Einzelmessung und der vierten Einzelmessung erfassten Messwerte für den q-Anteil des Motorstroms gebildet.

Bei einer weiteren Ausgestaltung der Erfindung werden für jede Messsequenz ein Mittelwert der bei der zweiten Einzelmessung und der dritten Einzelmessung ermittelten q-Anteile des Magnetflusses und ein Mittelwert der bei der zweiten Einzelmessung und der dritten Einzelmessung erfassten Messwerte für den q-Anteil des Motorstroms gebildet.

Die drei vorgenannten Ausgestaltungen der Erfindung fassen die Einzelmessungen einer Messsequenz zusammen, indem sie über bei den Einzelmessungen ermittelte Werte korrespondierender Anteile des Magnetflusses und des Motorstroms mitteln. Dadurch werden durch Bewegungen und Lageänderungen des Rotors verursachte Unterschiede zwischen Einzelmessungen und Messungenauigkeiten ausgeglichen.

Bei einer weiteren Ausgestaltung der Erfindung wird jede Messsequenz bei anfänglich verschwindender Bewegung des Rotors, genauer bei anfänglich verschwindender Relativbewegung des Rotors und des Stators des Synchronmotors, durchgeführt. Beispielsweise wird nach jeder Messsequenz eine Relativbewegung des Rotors und des Stators durch einen der Relativbewegung entgegenwirkenden Spannungspuls gestoppt.

Auch die vorgenannte Ausgestaltung der Erfindung zielt darauf ab, die Messungen bei möglichst geringer Bewegung des Rotors durchzuführen.

Bei einer weiteren Ausgestaltung der Erfindung werden Wertepaare, die jeweils aus einem Zielwert für den d-Anteil und einem Zielwert für den q-Anteil des Motorstroms bestehen, vorgegeben und für jedes Wertepaar wird eine Messsequenz durchgeführt, deren Messwerte für den d-Anteil und für den q-Anteil des Motorstroms mit den korrespondierenden Zielwerten des Wertepaares mit einer vorgegebenen Mindestgenauigkeit übereinstimmen. Beispielsweise wird zum Durchführen einer zu einem Wertepaar korrespondierenden Messsequenz eine Iteration über mehrere Messsequenzen durchgeführt.

Die vorgenannte Ausgestaltung der Erfindung zielt darauf ab, Messwerte für den d-Anteil und für den q-Anteil des Motorstroms in einer durch Wertepaare vorgegebenen Weise auf einen Messbereich zu verteilen, um den Messbereich möglichst vollständig abzudecken. Beispielsweise werden Wertepaare gewählt, die den Messbereich gleichmäßig rastern. Um einen durch ein Wertepaar charakterisierten Messpunkt zu treffen, wird beispielsweise eine Iteration über mehrere Messsequenzen durchgeführt bis die Messwerte für den d-Anteil und für den q-Anteil des Motorstroms mit den Zielwerten des Wertepaares mit der geforderten Mindestgenauigkeit übereinstimmen.

Bei einer weiteren Ausgestaltung der Erfindung werden der d-Anteil des Magnetflusses und der q-Anteil des Magnetflusses jeweils durch eine parametrisierte Funktion von dem d-Anteil und dem q-Anteil des Motorstroms approximiert und die Parameter dieser Funktionen werden aus bei den Messungen ermittelten d-Anteilen und q-Anteilen des Magnetflusses und den zugehörigen d-Anteilen und q-Anteilen des Motorstroms bestimmt. Die so bestimmten Funktionen können vorteilhaft für verschiedene quantitative Berechnungen von Motoreigenschaften des Synchronmotors genutzt werden, beispielsweise um sogenannte MTPA-Betriebspunkte (MTPA = Maximum Torque Per Ampere) zu berechnen. Diese sind Betriebspunkte, bei denen ein gewünschtes Drehmoment mit dem kleinsten dafür benötigten Motorstrom realisiert wird.

Ein erfindungsgemäßes Mess- und Auswertesystem für die Messung und Auswertung von Magnetflüssen eines permanenterregten Synchronmotors, dessen Motorspannungen durch einen Stromrichter erzeugt werden, umfasst

- eine Messeinheit, die eingerichtet ist, gemäß dem erfindungsgemäßen Verfahren Magnetflüsse des Synchronmotors in Abhängigkeit von Motorströmen des Synchronmotors zu messen, und
- eine Auswerteeinheit, die eingerichtet ist, aus den Messergebnissen der Messeinheit Induktivitäten des Synchronmotors und/oder ein Drehmoment des Synchronmotors und/oder ein Drehmoment-Strom-Verhältnis und/oder eine Reluktanzmomentkonstante des Synchronmotors in Abhängigkeit von den Motorströmen des Synchronmotors zu berechnen.

Das erfindungsgemäße Mess- und Auswertesystem nutzt aus, dass die erfindungsgemäße Messung von Magnetflüssen in Abhängigkeit von Motorströmen des Synchronmotors es ermöglicht, verschiedene betriebsrelevante Kenngrößen des Synchronmotors wie Induktivitäten, ein Drehmoment, ein Drehmoment-Strom-Verhältnis und eine Reluktanzmomentkonstante in Abhängigkeit von den Motorströmen des Synchronmotors zu berechnen. Konkrete Formeln für die Berechnung dieser Kenngrößen werden unten in der Figurenbeschreibung angegeben.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:

FIG 1 zeitliche Verläufe verschiedener Größen eines permanenterregten Synchronmotors bei einer Messung von Magnetflüssen in Abhängigkeit von Motorströmen,

FIG 2 eine Induktivität in Abhängigkeit von Motorströmen eines permanenterregten Synchronmotors,

FIG 3 eine unter Verwendung von gemäß dem erfindungsgemäßen Verfahren durchgeführten Messungen berechnete Kennlinie eines permanenterregten Synchronmotors und eine bei drehendem Rotor des Synchronmotors gemessene Kennlinie,

FIG 4 einen berechneten optimalen Lastwinkel in Abhängigkeit von einem Drehmoment eines permanenterregten Synchronmotors,

FIG 5 berechnete optimale d- und q-Anteile sowie den berechneten optimalen Betrag des Motorstroms in Abhängigkeit von dem Drehmoment eines permanenterregten Synchronmotors,

FIG 6 ein Blockdiagramm eines Ausführungsbeispiels eines Mess- und Auswertesystems für die Messung und Auswertung von Magnetflüssen in Abhängigkeit von Motorströmen eines permanenterregten Synchronmotors.

Einander entsprechende Teile sind in den Figuren mit denselben Bezugszeichen versehen.

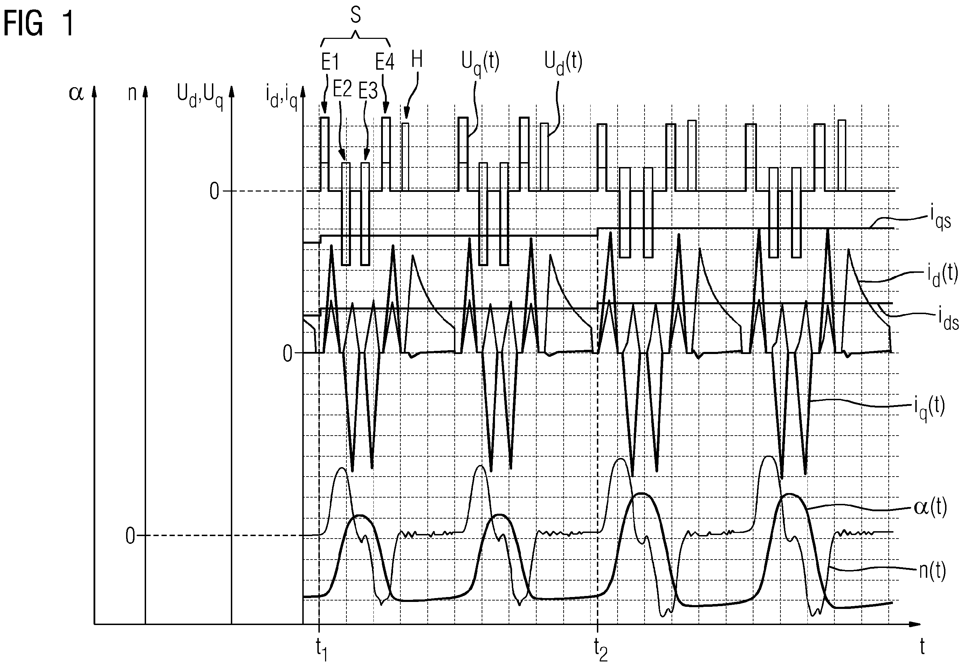

Figur 1 (FIG 1) illustriert ein Ausführungsbeispiel des erfindungsgemäßen Verfahrens zur Messung von Magnetflüssen eines permanenterregten Synchronmotors in Abhängigkeit von Motorströmen des Synchronmotors anhand von Verläufen verschiedener Größen $i_d$, $i_q$, $U_d$, $U_q$, n und $\alpha$ des Synchronmotors in Abhängigkeit von einer Zeit t. Dabei bezeichnen $i_d$ einen d-Anteil eines Motorstroms, $i_q$ einen q-Anteil des Motorstroms, $U_d$ einen d-Anteil einer Motorspannung, $U_q$ einen q-Anteil der Motorspannung, n eine Drehzahl und $\alpha$ einen Rotorlagewinkel des Synchronmotors. Die Motorspannungen werden durch einen Stromrichter, beispielsweise pulsdauermoduliert durch PDM-Signale des Stromrichters, erzeugt.

Beispielsweise ist der d-Anteil $U_d$ der Motorspannung die Differenz eines d-Anteils einer gemessenen Ausgangsspannung des Stromrichters und eines ohmschen Anteils eines Spannungsabfalls an einer Statorwicklung des Synchronmotors, und der q-Anteil $U_q$ der Motorspannung ist die Differenz eines q-Anteils der gemessenen Ausgangsspannung des Stromrichters und des ohmschen Anteils des Spannungsabfalls an der Statorwicklung des Synchronmotors. Alternativ ist der d-Anteil $U_d$ der Motorspannung die Differenz eines Sollwerts für den d-Anteil der Ausgangsspannung des Stromrichters und des ohmschen Anteils des Spannungsabfalls an der Statorwicklung des Synchronmotors und eines modellierten Spannungsabbildungsfehlers für den d-Anteil der Ausgangsspannung des Stromrichters, und der q-Anteil $U_q$ der Motorspannung ist die Differenz eines Sollwerts für den q-Anteil der Ausgangsspannung des Stromrichters und des ohmschen Anteils des Spannungsabfalls an der Statorwicklung des Synchronmotors und eines modellierten Spannungsabbildungsfehlers für den q-Anteil der Ausgangsspannung des Stromrichters. Der ohmsche Anteil des Spannungsabfalls an der Statorwicklung des Synchronmotors wird aus einem ohmschen Widerstand der Statorwicklung und dem Motorstrom berechnet.

Bei dem Verfahren werden Messsequenzen S von jeweils vier aufeinander folgenden Einzelmessungen E1 bis E4 durchgeführt. Bei jeder Einzelmessung E1 bis E4 wird eine Motorspannung als ein Spannungspuls bei anfänglich verschwindendem Motorstrom erzeugt. Aus dem d-Anteil $U_d$ der Motorspannung wird durch Integration über die Pulsdauer des Spannungspulses ein d-Anteil des Magnetflusses ermittelt. Aus dem q-Anteil $U_q$ der Motorspannung wird durch Integration über die Pulsdauer des Spannungspulses ein q-Anteil des Magnetflusses ermittelt.

Ferner werden bei jeder Einzelmessung E1 bis E4 ein Messwert für den d-Anteil $i_d$ und ein Messwert für den q-Anteil $i_q$ des Motorstroms erfasst. Beispielsweise ist der Messwert für den d-Anteil $i_d$ des Motorstroms ein Wert, für den ein Betrag des d-Anteils $i_d$ des Motorstroms maximal ist, und der Messwert für den q-Anteil $i_q$ des Motorstroms ist ein Wert, für den ein Betrag des q-Anteils $i_q$ des Motorstroms maximal ist.

Bei jeder Messsequenz S werden bei den Einzelmessungen E1 bis E4 jeweils wenigstens annähernd derselbe d-Anteil $U_d$ der Motorspannung und wenigstens annähernd derselbe Betrag des q-Anteils $U_q$ der Motorspannung erzeugt. Bei einer auf eine erste Einzelmessung E1 folgenden zweiten Einzelmessung E2 und bei einer auf die zweite Einzelmessung E2 folgenden dritten Einzelmessung E3 wird das Vorzeichen des q-Anteils $U_q$ der Motorspannung gegenüber der ersten Einzelmessung E1 invertiert. Bei einer auf die dritte Einzelmessung E3 folgenden vierten Einzelmessung E4 wird ein q-Anteil $U_q$ der Motorspannung mit demselben Vorzeichen wie bei der ersten Einzelmessung E1 erzeugt.

Für jede Messsequenz S werden ein Mittelwert der bei den Einzelmessungen ermittelten d-Anteile des Magnetflusses und ein Mittelwert der bei den Einzelmessungen E1 bis E4 erfassten Messwerte für den d-Anteil $i_d$ des Motorstroms gebildet. Ferner werden für jede Messsequenz S ein Mittelwert der bei der ersten Einzelmessung E1 und der vierten Einzelmessung E4 ermittelten q-Anteile des Magnetflusses und ein Mittelwert der bei der ersten Einzelmessung E1 und der vierten Einzelmessung E4 erfassten Messwerte für den q-Anteil $i_q$ des Motorstroms gebildet. Entsprechend werden für jede Messsequenz S ein Mittelwert der bei der zweiten Einzelmessung E2 und der dritten Einzelmessung E3 ermittelten q-Anteile des Magnetflusses und ein Mittelwert der bei der zweiten Einzelmessung E2 und der dritten Einzelmessung E3 erfassten Messwerte für den q-Anteil $i_q$ des Motorstroms gebildet.

Jede Messsequenz S wird bei anfänglich verschwindender Relativbewegung eines Rotors und eines Stators des Synchronmotors durchgeführt. Zu diesem Zweck wird nach jeder Messsequenz S eine Relativbewegung des Rotors und des Stators durch einen der Relativbewegung entgegenwirkenden Spannungs-Stopp-Puls H gestoppt, der nur einen d-Anteil aufweist.

Vorzugsweise werden für die Messungen Wertepaare $(i_{ds}, i_{qs})$ vorgegeben, die jeweils aus einem Zielwert $i_{ds}$ für den d-Anteil $i_d$ und einem Zielwert $i_{qs}$ für den q-Anteil $i_q$ des Motorstroms bestehen. Für jedes Wertepaar wird eine Messsequenz S durchgeführt, deren Messwerte für den d-Anteil und für den q-Anteil des Motorstroms mit den korrespondierenden Zielwerten $i_{ds}$ und $i_{qs}$ des Wertepaares mit einer vorgegebenen Mindestgenauigkeit übereinstimmen. Die Wertepaare werden beispielsweise derart vorgegeben, dass sie Bereiche für den d-Anteil $i_d$ und den q-Anteil $i_q$ des Motorstroms gleichmäßig rastern.

Zum Durchführen einer zu einem Wertepaar $(i_{ds}, i_{qs})$ korrespondierenden Messsequenz S wird beispielsweise eine Iteration mehrerer Messsequenzen S durchgeführt, wobei Motorspannungen $U_d$ und $U_q$ getrennt jeweils korrigiert werden, um die Zielwerte $i_{ds}$ und $i_{qs}$ mit der geforderten Mindestgenauigkeit zu erreichen. Beispielsweise können über eine parametrierte Motorinduktivität Motorspannungen $U_d$ und $U_q$ für den ersten Schritt der Iteration abgeschätzt beziehungsweise berechnet werden. Danach können mit den tatsächlichen Messwerten für $i_d$ und $i_q$ diese Vorgaben korrigiert und die Messung wiederholt werden bis die Zielwerte $i_{ds}$ und $i_{qs}$ mit der geforderten Mindestgenauigkeit erreicht sind. Hat man schon mehrere Messungen durchgeführt, können zur schnelleren Konvergenz der Iteration die differentiellen Induktivitäten von Messungen in der Nähe des jeweiligen Messpunktes verwendet werden.

Figur 1 zeigt beispielhaft eine Erhöhung der Zielwerte $i_{ds}$ und $i_{qs}$ zu Zeitpunkten $t_1$ und $t_2$. Nach jedem dieser Zeitpunkte werden zwei Messsequenzen S durchgeführt und die Zielwerte $i_{ds}$ und $i_{qs}$ werden jeweils bei der zweiten Messsequenz S mit der geforderten Mindestgenauigkeit erreicht.

Allerdings würde man abweichend von Figur 1 in der Praxis nicht unbedingt beide Zielwerte $i_{ds}$ und $i_{qs}$ gleichzeitig verändern. Beispielsweise beginnt man mit kleinen Zielwerten $i_{ds}$ und $i_{qs}$ und erhöht dann gemäß einem festgelegten Raster zunächst sukzessive den Zielwert $i_{qs}$ bis man den gewünschten Bereich für $i_q$ abgedeckt hat. Danach verändert man den Zielwert $i_{ds}$ und fährt für den geänderten Zielwert wieder das Raster der Zielwerte $i_{qs}$ ab. Für den d-Anteil $i_d$ müssen dabei Zielwerte $i_{ds}$ immer für beide Vorzeichen des Stroms vorgegeben werden. Beispielsweise kann man beginnend mit kleinen Strombeträgen erst die positiven Zielwerte $i_{ds}$ abarbeiten und danach ebenso mit kleinen Strombeträgen beginnend die negativen Zielwerte $i_{ds}$. Dies ist notwendig, weil ein permanenterregter Synchronmotor bezüglich $i_d$ nicht punkt- oder achsensymmetrisch ist. Bei einer Messsequenz S treten q-Anteile $i_q$ mit verschiedenen Vorzeichen auf. Beim q-Anteil $i_q$ liegt in der Regel eine Achsensymmetrie vor, so dass die Vorgabe von Zielwerten $i_{qs}$ für ein Vorzeichen ausreicht. Allerdings haben Messungen gezeigt, dass es diese Symmetrie nicht für alle Motoren gibt, sodass man die Symmetrie nicht immer ausnutzen kann und Zielwerte $i_{qs}$ ebenfalls für beide Vorzeichen verwenden muss. Bei den Messungen wird außerdem der Maximalstrom des Synchronmotors oder des Stromrichters berücksichtigt, sodass keine Zielwerte vorgegeben werden, die zu einer Überschreitung des Maximalstroms führen.

Aus der Messung des d-Anteils und des q-Anteils des Magnetflusses können sehr viele Informationen abgeleitet werden. Zum einen können die Induktivitäten $L_{dd}(i_d,i_q)$ und $L_{qq}(i_d,i_q)$ berechnet werden, indem man einen Anteil des Magnetflusses nach dem entsprechenden Anteil des Motorstroms differenziert. Außerdem erhält man auch die Querinduktivitäten $L_{aq}(i_a, i_q)$ und $L_{qd}(i_d, i_q)$, wenn man einen Anteil des Magnetflusses nach dem jeweils anderen Anteil des Motorstroms differenziert:

$$L_{dd}(i_{d1}, i_{q1}) = \frac{d\Psi_d(i_d, i_q)}{di_d}\Big|_{i_d=i_{d1}, i_q=i_{q1}}$$

$$bzw. \ L_{dd}\left(\frac{i_{d1}+i_{d2}}{2}, i_{q1}\right) = \frac{\Psi_d(i_{d2}, i_{q1}) - \Psi_d(i_{d1}, i_{q1})}{i_{d2}-i_{d1}}$$

$$L_{qq}(i_{d1}, i_{q1}) = \frac{d\Psi_q(i_d, i_q)}{di_q}\Big|_{i_d=i_{d1}, i_q=i_{q1}}$$

$$bzw.\ L_{qq}\left(i_{d1}, \frac{i_{q1} + i_{q2}}{2}\right) = \frac{\Psi_q(i_{d1}, i_{q2}) - \Psi_d(i_{d1}, i_{q1})}{i_{q2} - i_{q1}}$$

$$L_{qd}(i_{d1}, i_{q1}) = \frac{d\Psi_q(i_d, i_q)}{di_d}\bigg|_{i_d=i_{d1}, i_q=i_{q1}}$$

$$bzw.\ L_{qd}\left(\frac{i_{d1} + i_{d2}}{2}, i_{q1}\right) = \frac{\Psi_q(i_{d2}, i_{q1}) - \Psi_q(i_{d1}, i_{q1})}{i_{d2} - i_{d1}}$$

$$L_{dq}(i_{d1}, i_{q1}) = \frac{d\Psi_d(i_d, i_q)}{di_q}\bigg|_{i_d=i_{d1}, i_q=i_{q1}}$$

$$bzw.\ L_{dq}\left(i_{d1}, \frac{i_{q1} + i_{q2}}{2}\right) = \frac{\Psi_d(i_{d1}, i_{q2}) - \Psi_d(i_{d1}, i_{q1})}{i_{q2} - i_{q1}}$$

Hierbei bezeichnet $\psi_d$ den d-Anteil des Magnetflusses und $W_q$ bezeichnet den q-Anteil des Magnetflusses.

Der Flussmessung in d-Richtung fehlt noch der Offset des Permanentmagnetflusses $\Psi_{dPM}$, der im Stillstand des Synchronmotors nicht gemessen werden kann. Man kann den fehlenden Wert mit Kenntnis einer Spannungskonstante $k_E$ berechnen gemäß

$$\Psi_{dPM} = \frac{k_E}{\sqrt{6} \cdot \pi \cdot z_p}$$

Dabei ist $z_p$ die Polpaarzahl und die Spannungskonstante $k_E$ ist die verkettete Effektivspannung im Leerlauf dividiert durch die Drehzahl des Synchronmotors. Der Wert von $\Psi_{dPM}$ muss zu einem gemessenen d-Anteil des Magnetflusses addiert werden, um $\Psi_d$ zu erhalten.

Alternativ kann $\Psi_{dPM}$ gemessen werden, indem im Leerlauf des Synchronmotors bei geeigneter Drehzahl die Motorspannung gemessen wird (daraus könnte man auch $k_E$ bestimmen).

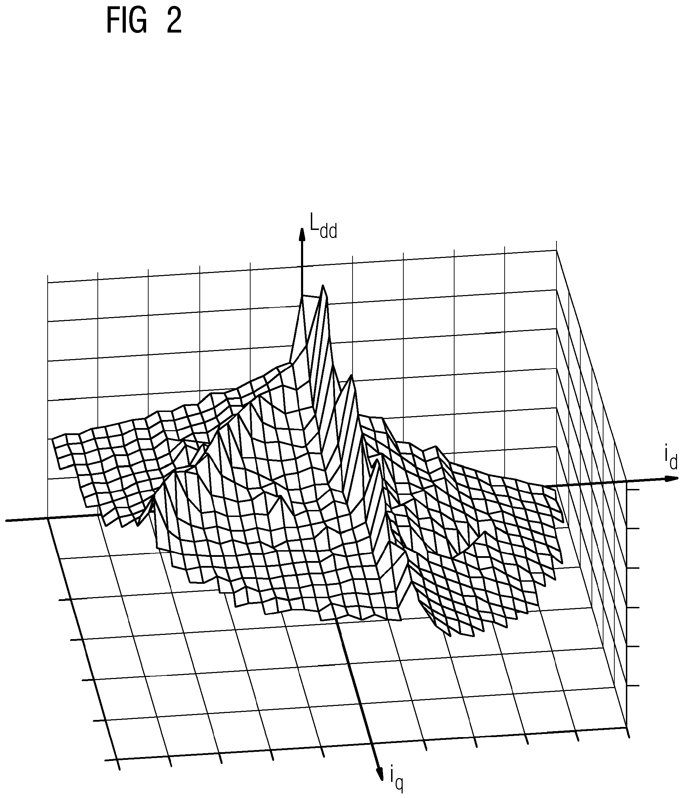

Figur 2 (FIG 2) zeigt beispielhaft ein Ergebnis einer Bestimmung der Induktivität $L_{dd}$ in Abhängigkeit von $i_d$ und $i_q$.

Die Messung der Magnetflüsse, das heißt des d-Anteils und q-Anteils des Magnetflusses, in Abhängigkeit von $i_d$ und $i_q$ funktioniert prinzipiell auch lageabhängig, das heißt in Abhängigkeit von dem Rotorlagewinkel $\alpha$ des Synchronmotors, mit der Unschärfe der Bewegung. Synchronmotoren mit Einzelzahnwicklung haben häufig auch eine Lageabhängigkeit der Magnetflüsse, so dass man die Magnetflüsse auch abhängig von der Rotorlage messen kann.

Mit den Magnetflüssen kann ferner das Drehmoment des Synchronmotors berechnet werden gemäß

$$M_i(i_d, i_q) = \frac{3}{2} \cdot z_p \cdot \left(\Psi_d(i_d, i_q) \cdot i_q - \Psi_q(i_d, i_q) \cdot i_d\right)$$

Dabei wurden die Rastmomente vernachlässigt beziehungsweise die Rastmomente müssen gesondert betrachtet werden.

Das aus den gemessenen Magnetflüssen berechnete Drehmoment berücksichtigt die Sättigungsabhängigkeit. Mit dem Drehmoment kann man beispielsweise eine $k_T$-Kennlinie $k_T(i_q)$ für ein Drehmoment-Strom-Verhältnis $k_T$, das den Zusammenhang des Drehmoments und des q-Anteils $i_q$ des Motorstroms beschreibt, berechnen gemäß

$$k_T(i_q) = \sqrt{2} \cdot \frac{M_i(0, i_q)}{i_q} = \frac{M_i(0, i_q)}{i_{qeff}} = \frac{3}{\sqrt{2}} \cdot z_p \cdot \left( \Psi_{dPM} + \Psi_d(0, i_q) \right)$$

oder auch die Reluktanzmomentkonstante $k_{TRel}(i_d, i_q)$ für alle Arbeitspunkte berechnen gemäß

$$k_{TRel}(i_d, i_q) = 2 \cdot \frac{M_i(i_d, i_q) - M_i(0, i_q)}{i_d \cdot i_q} = \frac{M_i(i_d, i_q) - M_i(0, i_q)}{i_{deff} \cdot i_{qeff}}$$

$$= 3 \cdot z_p \cdot \frac{\left[ \Psi_d(i_d, i_q) - \Psi_d(0, i_q) \right] \cdot i_q - \Psi_q(i_d, i_q) \cdot i_d}{i_d \cdot i_q}$$

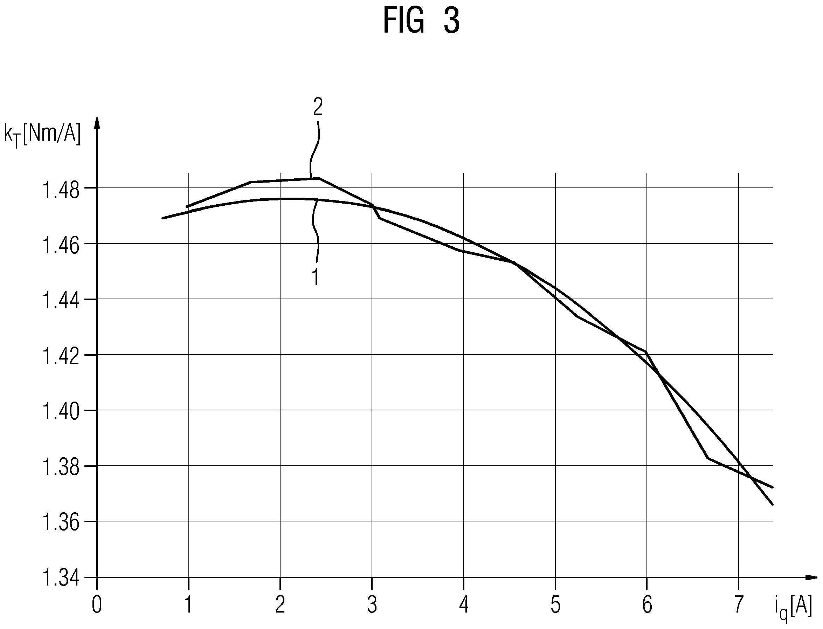

Figur 3 (FIG 3) zeigt beispielhaft eine derart berechnete $k_T$-Kennlinie 1 im Vergleich zu einer bei drehendem Rotor eines Synchronmotors gemessenen $k_T$-Kennlinie 2. Deutlich erkennbar ist die gute Übereinstimmung der beiden Ergebnisse.

Eine weitere Möglichkeit besteht darin, die Magnetflüsse jeweils mit einer geeigneten parametrisierten Funktion von $i_d$ und $i_q$ zu approximieren und damit optimale Betriebspunkte zu berechnen. Derartige Funktionen sind beispielsweise

$$\Psi_d(i_d, i_q) = \frac{ka_0 \cdot i_d + ka_1 \cdot i_d^2 + ka_2 \cdot i_d^3 + kb_0 \cdot |i_q| + kb_1 \cdot i_q^2 + kb_2 \cdot i_q^2 \cdot i_d}{1 + ka_3 \cdot i_d + ka_4 \cdot i_d^2 + kb_3 \cdot |i_q| + kb_4 \cdot i_q^2 \cdot i_d}$$

$$\Psi_q(i_d, i_q) = \frac{kc_0 \cdot i_q + kd_0 \cdot i_d \cdot i_q + kd_1 \cdot i_d \cdot i_q \cdot |i_q| + kd_2 \cdot i_d^2 \cdot i_q + kd_3 \cdot i_d^2 \cdot i_q \cdot |i_q|}{1 + kc_1 \cdot |i_q| + kc_2 \cdot i_q^2 + kd_4 \cdot i_d + kd_5 \cdot i_d^2}$$

$$= i_q \cdot \frac{kc_0 + kd_0 \cdot i_d + kd_1 \cdot i_d \cdot |i_q| + kd_2 \cdot i_d^2 + kd_3 \cdot i_d^2 \cdot |i_q|}{1 + kc_1 \cdot |i_q| + kc_2 \cdot i_q^2 + kd_4 \cdot i_d + kd_5 \cdot i_d^2}$$

Hier sind $ka_0$ bis $ka_4$, $b_0$ bis $kb_4$, $kc_0$ bis $kc_2$ und $kd_0$ bis $kd_5$ Parameter, die aus bei den Messungen ermittelten d-Anteilen und q-Anteilen des Magnetflusses und den zugehörigen d-Anteilen und q-Anteilen des Motorstroms bestimmt werden.

Mit den derart parametrisierten Magnetflüssen werden beispielsweise MTPA-Betriebspunkte berechnet.

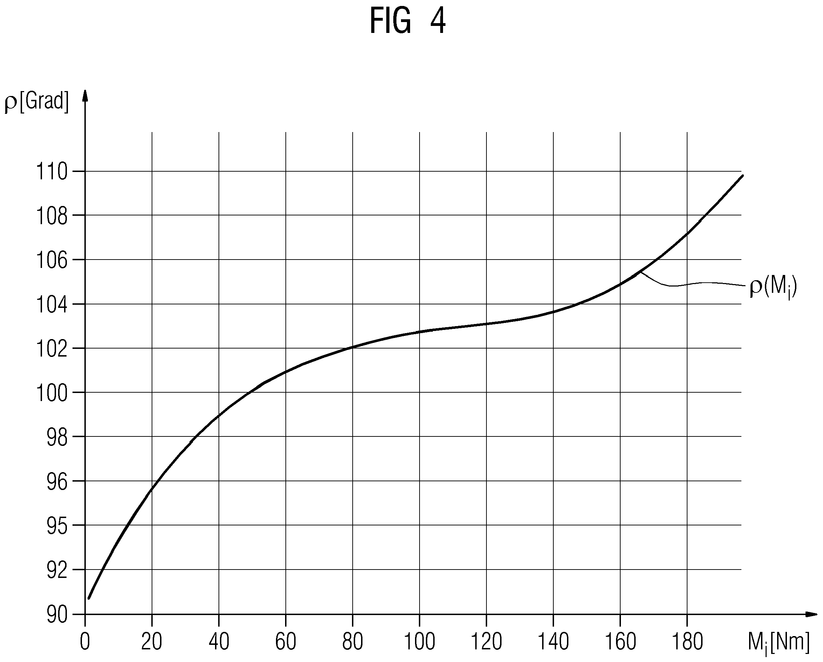

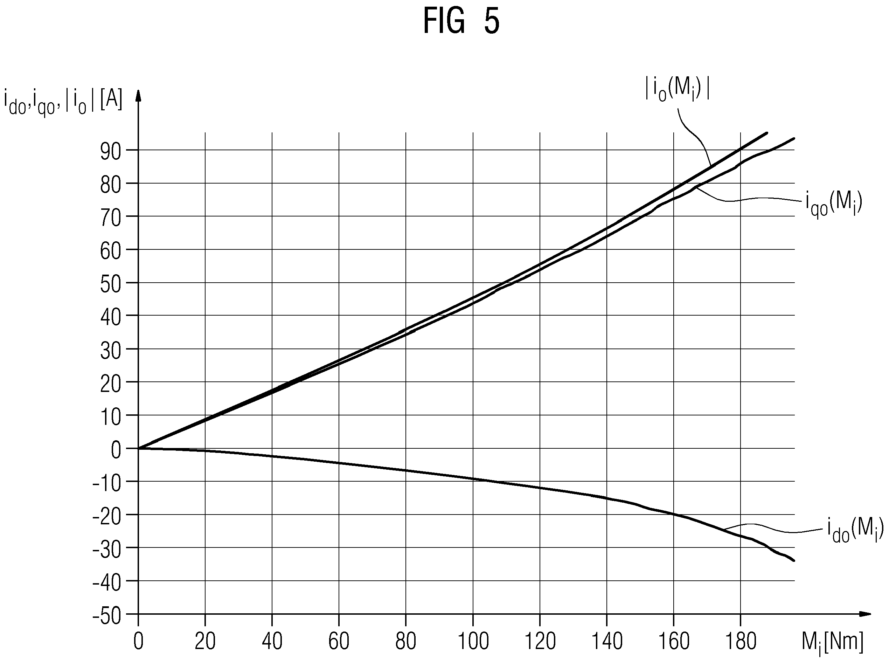

Figur 4 (FIG 4) und Figur 5 (FIG 5) zeigen beispielhaft derart berechnete MTPA-Betriebspunkte für einen Synchronmotor. Dabei zeigt Figur 4 einen berechneten optimalen Lastwinkel $\rho$ in Abhängigkeit von dem Dehmoment $M_i$ und Figur 5 zeigt berechnete optimale d- und q-Stromanteile $i_{do}$ und $i_{qo}$ sowie den berechneten optimalen Strombetrag $|i_o|$ des Motorstroms in Abhängigkeit von dem Drehmoment $M_i$.

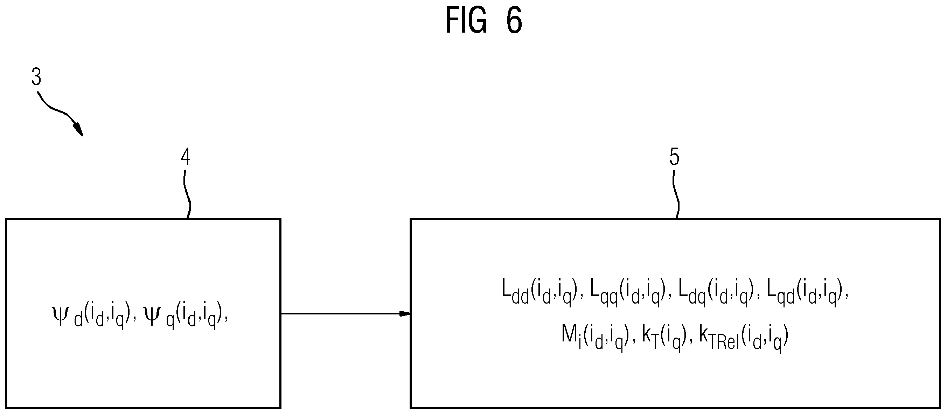

Figur 6 (FIG 6) zeigt ein Blockdiagramm eines Ausführungsbeispiels eines Mess- und Auswertesystems 3 für die Messung und Auswertung von Magnetflüssen $\psi_d$, $\psi_q$ eines permanenterregten Synchronmotors, dessen Motorspannungen durch einen Stromrichter erzeugt werden, in Abhängigkeit von Motorströmen $i_d$, $i_q$ des Synchronmotors. Das Mess- und Auswertesystem 3 umfasst eine Messeinheit 4, die eingerichtet ist, gemäß dem oben beschriebenen erfindungsgemäßen Verfahren Magnetflüsse $\psi_d$, $\psi_q$ des Synchronmotors in Abhängigkeit von Motorströmen $i_d$, $i_q$ des Synchronmotors zu messen. Ferner umfasst das Mess- und Auswertesystem 3 eine Auswerteeinheit 5, die eingerichtet ist, aus den Messergebnissen der Messeinheit 3 Induktivitäten $L_{dd}$, $L_{qq}$, $L_{dq}$, $L_{qd}$ des Synchronmotors, ein Drehmoment $M_i$ des Synchronmotors, ein Drehmoment-Strom-Verhältnis $k_T$ und eine Reluktanzmomentkonstante $k_{TRel}$ des Synchronmotors in Abhängigkeit von den Motorströmen $i_d$, $i_q$ des Synchronmotors zu berechnen. Die Auswerteeinheit 5 ist beispielsweise als ein Computerprogramm ausgebildet, das auf einem Prozessor ausgeführt wird und die oben genannten Größen $L_{dd}$, $L_{qq}$, $L_{dq}$, $L_{qd}$, $M_i$, $k_T$ und $k_{TRel}$ des Synchronmotors gemäß oben angegebenen Formeln berechnet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zur Messung von Magnetflüssen ($\psi_d$, $\psi_q$) eines permanenterregten Synchronmotors, dessen Motorspannungen durch einen Stromrichter erzeugt werden, in Abhängigkeit von Motorströmen ($i_d$, $i_q$) des Synchronmotors, wobei mehrere Einzelmessungen (E1 bis E4) durchgeführt werden und bei jeder Einzelmessung (E1 bis E4)

    - eine Motorspannung als ein Spannungspuls bei anfänglich verschwindendem Motorstrom erzeugt wird,
    - aus einem d-Anteil ($U_d$) der Motorspannung durch Integration über die Pulsdauer des Spannungspulses ein d-Anteil ($\psi_d$) des Magnetflusses ermittelt wird,
    - aus einem q-Anteil ($U_q$) der Motorspannung durch Integration über die Pulsdauer des Spannungspulses ein q-Anteil ($\psi_q$) des Magnetflusses ermittelt wird und
    - ein Messwert für einen d-Anteil ($i_d$) und ein Messwert für einen q-Anteil ($i_q$) des Motorstroms erfasst werden.

2. Verfahren nach Anspruch 1, wobei der d-Anteil ($U_d$) der Motorspannung die Differenz eines d-Anteils einer gemessenen Ausgangsspannung des Stromrichters und eines ohmschen Anteils eines Spannungsabfalls an einer Statorwicklung des Synchronmotors ist und der q-Anteil ($U_q$) der Motorspannung die Differenz eines q-Anteils der gemessenen Ausgangsspannung des Stromrichters und des ohmschen Anteils des Spannungsabfalls an der Statorwicklung des Synchronmotors ist.

3. Verfahren nach Anspruch 1, wobei der d-Anteil ($U_d$) der Motorspannung die Differenz eines Sollwerts für einen d-Anteil einer Ausgangsspannung des Stromrichters und eines ohmschen Anteils eines Spannungsabfalls an einer Statorwicklung des Synchronmotors und eines modellierten Spannungsabbildungsfehlers für den d-Anteil der Ausgangsspannung des Stromrichters ist und der q-Anteil ($U_q$) der Motorspannung die Differenz eines Sollwerts für einen q-Anteil der Ausgangsspannung des Stromrichters und des ohmschen Anteils des Spannungsabfalls an der Statorwicklung des Synchronmotors und eines modellierten Spannungsabbildungsfehlers für den q-Anteil der Ausgangsspannung des Stromrichters ist.

4. Verfahren nach Anspruch 2 oder 3, wobei der ohmsche Spannungsabfall an der Statorwicklung des Synchronmotors aus einem ohmschen Widerstand der Statorwicklung und dem Motorstrom berechnet wird.

5. Verfahren nach einem der vorhergehenden Ansprüche, wobei der bei einer Einzelmessung (E1 bis E4) erfasste Messwert für den d-Anteil ($i_d$) des Motorstroms ein Wert ist, für den ein Betrag des d-Anteils ($i_d$) des Motorstroms maximal ist, und der bei einer Einzelmessung (E1 bis E4) erfasste Messwert für den q-Anteil ($i_q$) des Motorstroms ein Wert ist, für den ein Betrag des q-Anteils ($i_q$) des Motorstroms maximal ist.

6. Verfahren nach einem der vorhergehenden Ansprüche, wobei Messsequenzen (S) von jeweils vier aufeinander folgenden Einzelmessungen (E1 bis E4) durchgeführt werden, wobei bei jeder Messsequenz (S)

    - bei den Einzelmessungen (E1 bis E4) jeweils wenigstens annähernd derselbe d-Anteil ($U_d$) der Motorspannung und wenigstens annähernd derselbe Betrag des q-Anteils ($U_q$) der Motorspannung erzeugt werden,
    - bei einer auf eine erste Einzelmessung (E1) folgenden zweiten Einzelmessung (E2) und bei einer auf die zweite Einzelmessung (E2) folgenden dritten Einzelmessung (E3) das Vorzeichen des q-Anteils ($U_q$) der Motorspannung gegenüber der ersten Einzelmessung (E1) invertiert wird und
    - bei einer auf die dritte Einzelmessung (E3) folgenden vierten Einzelmessung (E4) ein q-Anteil ($U_q$) der Motorspannung mit demselben Vorzeichen wie bei der ersten Einzelmessung (E1) erzeugt wird.

7. Verfahren nach Anspruch 6, wobei für jede Messsequenz (S) ein Mittelwert der bei den Einzelmessungen (E1 bis E4) ermittelten d-Anteile ($\psi_d$) des Magnetflusses und ein Mittelwert der bei den Einzelmessungen (E1 bis E4) erfassten Messwerte für den d-Anteil ($i_d$) des Motorstroms gebildet werden.

8. Verfahren nach Anspruch 6 oder 7, wobei für jede Messsequenz (S) ein Mittelwert der bei der ersten Einzelmessung (E1) und der vierten Einzelmessung (E4) ermittelten q-Anteile ($\psi_q$) des Magnetflusses und ein Mittelwert der bei der ersten Einzelmessung (E1) und der vierten Einzelmessung (E4) erfassten Messwerte für den q-Anteil ($i_q$) des Motorstroms gebildet werden.

9. Verfahren nach einem der Ansprüche 6 bis 8, wobei für jede Messsequenz (S) ein Mittelwert der bei der zweiten Einzelmessung (E2) und der dritten Einzelmessung (E3) ermittelten q-Anteile ($\psi_q$) des Magnetflusses und ein Mittelwert der bei der zweiten Einzelmessung (E2) und der dritten Einzelmessung (E3) erfassten Messwerte für den q-Anteil ($i_q$) des Motorstroms gebildet werden.

10. Verfahren nach einem der Ansprüche 6 bis 9, wobei jede Messsequenz (S) bei anfänglich verschwindender Relativbewegung eines Rotors und eines Stators des Synchronmotors durchgeführt wird.

11. Verfahren nach einem der Ansprüche 6 bis 10, wobei nach jeder Messsequenz (S) eine Relativbewegung des Rotors und des Stators durch einen der Relativbewegung entgegenwirkenden Spannungs-Stopp-Puls (H) gestoppt wird.

12. Verfahren nach einem der Ansprüche 6 bis 11, wobei Wertepaare, die jeweils aus einem Zielwert ($i_{ds}$) für den d-Anteil ($i_d$) und einem Zielwert ($i_{qs}$) für den q-Anteil ($i_q$) des Motorstroms bestehen, vorgegeben werden und für jedes Wertepaar eine Messsequenz (S) durchgeführt wird, deren Messwerte für den d-Anteil ($i_d$) und für den q-Anteil ($i_q$) des Motorstroms mit den korrespondierenden Zielwerten ($i_{ds}$, $i_{qs}$) des Wertepaares mit einer vorgegebenen Mindestgenauigkeit übereinstimmen.

13. Verfahren nach Anspruch 12, wobei zum Durchführen einer zu einem Wertepaar korrespondierenden Messsequenz (S) eine Iteration über mehrere Messsequenzen (S) durchgeführt wird.

14. Verfahren nach einem der vorhergehenden Ansprüche, wobei der d-Anteil ($\psi_d$) des Magnetflusses und der q-Anteil ($\psi_q$) des Magnetflusses jeweils durch eine parametrisierte Funktion von dem d-Anteil ($i_d$) und dem q-Anteil ($i_q$) des Motorstroms approximiert werden und die Parameter dieser Funktionen aus bei den Messungen ermittelten d-Anteilen ($\psi_d$) und q-Anteilen ($\psi_q$) des Magnetflusses und den zugehörigen d-Anteilen ($i_d$) und q-Anteilen ($i_q$) des Motorstroms bestimmt werden.

15. Mess- und Auswertesystem (3) für die Messung und Auswertung von Magnetflüssen ($\psi_d$, $\psi_q$) eines permanenterregten Synchronmotors, dessen Motorspannungen durch einen Stromrichter erzeugt werden, in Abhängigkeit von Motorströmen ($i_d$, $i_q$) des Synchronmotors, das Mess- und Auswertesystem (3) umfassend

- eine Messeinheit (4), die eingerichtet ist, gemäß einem der vorhergehenden Ansprüche Magnetflüsse ($\psi_d$, $\psi_q$) des Synchronmotors in Abhängigkeit von Motorströmen ($i_d$, $i_q$) des Synchronmotors zu messen, und
- eine Auswerteeinheit (5), die eingerichtet ist, aus den Messergebnissen der Messeinheit (4) Induktivitäten ($L_{dd}$, $L_{qq}$, $L_{dq}$, $L_{qd}$) des Synchronmotors und/oder ein Drehmoment ($M_i$) des Synchronmotors und/oder ein Drehmoment-Strom-Verhältnis ($k_T$) und/oder eine Reluktanzmomentkonstante ($k_{TRel}$) des Synchronmotors in Abhängigkeit von den Motorströmen ($i_d$, $i_q$) des Synchronmotors zu berechnen.

FIG 1

EP 4 400 851 A1

FIG 2

FIG 3

EP 4 400 851 A1

FIG 4

# FIG 5

EP 4 400 851 A1

FIG 6

$\psi_d(i_d,i_q),\ \psi_q(i_d,i_q),$

$L_{dd}(i_d,i_q),\ L_{qq}(i_d,i_q),\ L_{dq}(i_d,i_q),\ L_{qd}(i_d,i_q),$

$M_i(i_d,i_q),\ k_T(i_q),\ k_{TRel}(i_d,i_q)$

EP 4 400 851 A1

Europäisches
Patentamt

European
Patent Office

Office européen
des brevets

# EUROPÄISCHER RECHERCHENBERICHT

**Nummer der Anmeldung**

**EP 23 15 1751**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2017/179859 A1 (WEST NATHAN THOMAS [US] ET AL) 22. Juni 2017 (2017-06-22) | 1-5,14, 15 | INV. G01R31/34 G01R33/02 H02P21/14 |
| A | * Abbildungen 1-6 * * Absatz [0014] – Absatz [0030] * ----- | 6-13 | |
| A | US 2022/196741 A1 (MUSAK MAREK [SK] ET AL) 23. Juni 2022 (2022-06-23) * Absätze [0015], [0051] – [0056] * * Abbildungen 1-8 * ----- | 1-15 | |

**RECHERCHIERTE SACHGEBIETE (IPC)**

G01R
H02P

Der vorliegende Recherchenbericht wurde für alle Patentansprüche erstellt

| Recherchenort | Abschlußdatum der Recherche | Prüfer |
|---|---|---|
| München | 30. Juni 2023 | Sedlmaier, Stefan |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
.................................................................................................
& : Mitglied der gleichen Patentfamilie, übereinstimmendes
   Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 23 15 1751

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-06-2023

| Im Recherchenbericht angeführtes Patentdokument | Datum der Veröffentlichung | Mitglied(er) der Patentfamilie | Datum der Veröffentlichung |
|---|---|---|---|
| US 2017179859 A1 | 22-06-2017 | CN 105144554 A | 09-12-2015 |
| | | DK 2941818 T3 | 20-06-2022 |
| | | EP 2941818 A1 | 11-11-2015 |
| | | KR 20150132097 A | 25-11-2015 |
| | | US 2015357955 A1 | 10-12-2015 |
| | | US 2017179859 A1 | 22-06-2017 |
| | | WO 201407496 A1 | 10-07-2014 |
| US 2022196741 A1 | 23-06-2022 | KEINE | |

EPO FORM P0461

Für nähere Einzelheiten zu diesem Anhang : siehe Amtsblatt des Europäischen Patentamts, Nr.12/82